# EUROPÄISCHE PATENTSCHRIFT

(11) **EP 2 956 783 B1**
(45) Veröffentlichungstag und Bekanntmachung des Hinweises auf die Patenterteilung: **28.12.2016**
(21) Anmeldenummer: 14701914.5
(22) Anmeldetag: 24.01.2014
(51) Int. Cl.: G01R 31/36

(54) **VERFAHREN ZUM TESTEN EINES ENERGIESPEICHERS IN EINEM KRAFTFAHRZEUG**
METHOD FOR TESTING AN ENERGY STORE IN A MOTOR VEHICLE
PROCÉDÉ DE TEST D'UN ACCUMULATEUR D'ÉNERGIE DANS UN VÉHICULE À MOTEUR

(30) Priorität: 14.02.2013 DE 102013002589
(43) Veröffentlichungstag der Anmeldung: 23.12.2015
(73) Patentinhaber: Audi AG, 85045 Ingolstadt (DE)
(72) Erfinder: BARTH, Karsten, 09120 Chemnitz (DE); WAGNER, Rolf, 65451 Kelsterbach (DE)
(74) Vertreter: Herbst, Matthias Heinz
(86) Internationale Anmeldenummer: PCT/EP2014/000181
(87) Internationale Veröffentlichungsnummer: WO 2014/124733

(56) Entgegenhaltungen:
- EP-A1- 1 278 072
- JP-A- 2005 077 128
- US-A- 5 969 529

## Beschreibung

Die Erfindung betrifft ein Verfahren zum Testen eines ersten Energiespeichers in einem Kraftfahrzeug, umfassend einen ersten Energiespeicher zum Betrieb mehrerer Fahrzeugsysteme und einen zweiten Energiespeicher, der zumindest die zum Starten des Kraftfahrzeugs benötigte elektrische Energie zur Verfügung stellt, sowie eine Steuereinrichtung.

Umweltfreundlichkeit und ein geringer Kraftstoffverbrauch entwickeln sich zunehmend zu entscheidenden Auswahlkriterien für die Wahl eines Kraftfahrzeugs. Dies führt zu einer zunehmenden Entwicklung von Kraftfahrzeugen, die einen Elektro- oder Hybridantrieb aufweisen. Insbesondere Kraftfahrzeuge, bei denen die Hybridisierung über eine reine Start-Stopp-Automatik mit Energierückgewinnung hinausgeht, weisen zum Betrieb des mindestens einen im Kraftfahrzeug vorhandenen Elektromotors oder Startgenerators in der Regel einen Höherspannungsenergiespeicher auf. Eine Vielzahl der Verbraucher im Bordnetz werden jedoch vorteilhaft mit einer niedrigeren Betriebsspannung, beispielsweise 12 V, betrieben. Daher ist häufig auch ein Niederspannungsenergiespeicher vorgesehen. Häufig ist auch bei Verwendung nur einer Betriebsspannung in einem Kraftfahrzeug ein Nutzung von zwei getrennten Bordnetzen mit jeweils zugeordnetem Energiespeicher vorteilhaft. Das Kraftfahrzeug umfasst also zwei Bordnetze, von denen häufig eines mit hohen Spannungen und eines mit niedrigen Spannungen betrieben wird. Diese Bordnetze sind häufig über einen DC/DC-Konverter gekoppelt.

Um ein zuverlässiges Funktionieren aller Fahrzeugsysteme sicherzustellen ist es notwendig, dass die Leistungsfähigkeit und der Ladezustand von Energiespeichern im Kraftfahrzeug getestet werden kann. Bei einem konventionellen Kraftfahrzeug mit einem Bordnetz, einem Energiespeicher und Verbrennungsmotor wird die Leistungsfähigkeit des Energiespeichers bereits beim Anlassen getestet, da in diesem Fall sehr große Ströme entnommen werden. Bleibt die am Energiespeicher abfallende Spannung auch in diesem Fall hoch genug, um ein Anlassen des Kraftfahrzeugs zu ermöglichen, so ist davon auszugehen, dass der Zustand des Energiespeichers ausreichend ist, um einen sicheren Betrieb aller Fahrzeugsysteme sicherzustellen.

Insbesondere in Hybridfahrzeugen dient nun häufig der bzw. einer der ohnehin vorhandenen Elektromotoren bzw. ein Startergenerator, insbesondere ein riemengetriebene Startergenerator oder ein Kurbelwellen-Startergenerator, als Starter für den Verbrennungsmotor. Der Starter des Verbrennungsmotors wird in diesem Fall teilweise aus einem zweiten Energiespeicher gespeist, der neben einem ersten Energiespeicher, der weitere Fahrzeugsysteme speist, ins Fahrzeug integriert ist. Damit wird der erste Energiespeicher nicht belastet. In der Regel wird zwar die am ersten Energiespeicher abfallende Spannung gemessen, aus der im nicht belasteten Zustand abfallenden Spannung kann jedoch nur eingeschränkt auf den Ladezustand und die Leistungsfähigkeit des ersten Energiespeichers geschlossen werden.

Wie eingangs erläutert ist in vielen Kraftfahrzeugen der erste Energiespeicher ein Niederspannungsenergiespeicher und der zweite Energiespeicher ein Höherspannungsenergiespeicher. In den Beispielen und Beschreibungen dieser Anmeldung werden daher teilweise zur größeren Klarheit die Bezeichnungen Niederspannungsenergiespeicher für den ersten Energiespeicher und Höherspannungsenergiespeicher für den zweiten Energiespeicher verwendet. Dies soll die Allgemeinheit dieser Beschreibungen und Beispiele jedoch nicht einschränken, da selbstverständlich auch beide Energiespeicher die gleiche Nennspannung aufweisen können und es sogar möglich ist, das der erste Energiespeicher eine höhere Nennspannung aufweist als der zweite Energiespeicher.

Der Erfindung liegt damit die Aufgabe zugrunde, ein Verfahren zum Testen eines ersten Energiespeichers anzugeben, das ein zuverlässigeres Testen der ausreichenden Leistungsfähigkeit und des ausreichenden Ladezustands des ersten Energiespeichers zum Betrieb der Fahrzeugsysteme erlaubt.

US 5,969,529 offenbart eine Spannungsüberwachungsschaltung für einen Energiespeicher, die eine Pseudo-Last bestehend aus einem oder mehreren Widerständen benutzt.

Die Aufgabe wird erfindungsgemäß durch ein Verfahren nach Anspruch 1 und durch eine Vorrichtung nach Anspruch 13 gelöst.

Das erfindungsgemäße Verfahren beruht auf der Idee, dass eine zuverlässige Aussage über die Leistungsfähigkeit und den Ladezustand eines Energiespeichers nur im belasteten Zustand möglich ist. Um sicherzustellen, dass der erste Energiespeicher allen Belastungen gewachsen ist, die im Fahrbetrieb auftreten, sollte die Belastung, unter der das Verhalten des ersten Energiespeichers untersucht wird, mindestens so groß sein wie die Belastung im Fahrbetrieb. Besonders vorteilhaft ist es, wenn die Belastung zum Testen größer ist als die Belastung durch alle Fahrzeugsysteme, das heißt, die Impedanz des Verbrauchers, der zum Testen mit dem ersten Energiespeicher verbunden ist geringer als die Impedanz einer Parallelschaltung der gleichzeitig zu nutzenden Fahrzeugsysteme. Vorteilhafterweise sollte der Verbraucher eine niedrige Induktivität aufweisen. In diesem Fall fließen sofort mit dem Verbinden des Verbrauchers mit dem ersten Energiespeicher große Ströme und es können sehr kurze Zeitintervalle zum Testen des ersten Energiespeichers genutzt werden.

Wird nun während des Zeitintervalls, in dem der erste Energiespeicher mit dem Verbraucher verbunden ist, die am ersten Energiespeicher abfallende Spannung gemessen, so ist diese Spannung ein sehr gutes Maß für die Leistungsfähigkeit des ersten Energiespeichers. Ist das Zeitintervall ausreichend lang, so dass Induktivität und Kapazität des Energiespeichers sowie des mit dem Energiespeicher verbundenen Verbrauchers keinen Einfluss auf die gemessene Spannung haben, so ist diese Spannung proportional zum Quotienten aus dem Widerstand des Verbrauchers und der Summe des Widerstands des Verbrauchers und des Innenwiderstandes des ersten Energiespeichers. Die Messgröße ist also bei festem Widerstand des Verbrauchers ausschließlich vom Innenwiderstand des Energiespeichers abhängig. Der Innenwiderstand eines Energiespeichers ist jedoch das entscheidende Kriterium für die Leistungsfähigkeit eines Energiespeichers.

Fällt also im erfindungsgemäßen Verfahren die Spannung, die am ersten Energiespeicher abfällt, bei der Messung in dem Zeitintervall unter einen vorgegebenen Grenzwert, so entspricht dies dem Überschreiten eines maximalen Innenwiderstands des ersten Ergiespeichers. Da die elektrische Energie zum Starten des Kraftfahrzeugs dem zweiten Energiespeicher entstammt, ist in diesem Fall dennoch ein Betrieb des Kraftfahrzeugs möglich. Erfindungsgemäß wird jedoch ein Warnsignal durch eine Ausgaberichtung ausgegeben, um den Fahrer auf die eingeschränkte Leistungsfähigkeit des ersten Energiespeichers hinzuweisen. Der Fahrer wird damit informiert, dass es möglich ist, dass im Fahrbetrieb nicht alle Fahrzeugsysteme ausreichend versorgt werden können.

Es ist auch möglich, dass abhängig von der gemessenen Spannung und dem Fahrzustand des Kraftfahrzeugs weitere Einstellungen am Kraftfahrzeug verändert werden. So kann beispielsweise in dem Fall, dass das Kraftfahrzeug noch nicht in Betrieb gesetzt wurde und eine sehr niedrige Spannung gemessen wurde, ein Start des Kraftfahrzeugs vollständig verhindert werden. Es ist auch möglich, dass abhängig von der gemessenen Spannung verschiedene Arten von Warnsignalen ausgegeben werden. Beispielsweise kann bei Unterschreiten eines ersten Grenzwertes eine Warnleuchte aktiviert wird, die bei Unterschreiten eines weiteren, tieferen Grenzwertes blinkt und bei Unterschreiten eines dritten noch tieferen Grenzwertes durch ein akustisches Signal ergänzt wird.

Es ist auch möglich, dass gezielt die Funktion einzelner, nicht sicherheitsrelevanter Fahrzeugsysteme unterbunden wird. Insbesondere können bei Unterschreiten eines ersten Grenzwerts beispielsweise Entertainmentsysteme im Kraftfahrzeug abgeschaltet werden und bei Unterschreitung eines weiteren Grenzwertes können alle nicht sicherheitsrelevanten durch den ersten Energiespeicher gespeisten Fahrzeugsysteme abgeschaltet werden. Es ist auch möglich, dass der erste Energiespeicher bei Unterschreiten eines bestimmten Spannungsgrenzwertes vollständig vom Bordnetz getrennt wird, um beispielsweise einen ausschließlichen Betrieb aller Niederspannungskomponenten über den DC/DC-Konverter und den Höherspannungsenergiespeicher zu ermöglichen oder um eine Tiefentladung des ersten Energiespeichers zu vermeiden.

Es ist auch möglich, dass das Kraftfahrzeug mehrere Steuereinrichtungen aufweist. In diesem Fall kann die Ausgabe des Signals an weitere fahrzeug-Komponenten auch durch eine andere Steuereinrichtung erfolgen, als die Verbindung des ersten Energiespeichers mit dem Verbraucher. Zudem können auch mehrere Verbraucher mit dem ersten Energiespeicher verbunden werden.

Es ist möglich, dass der erste Energiespeicher ein Niederspannungsenergiespeicher und der zweite Energiespeicher ein Höherspannungsenergiespeicher ist. Viele Komponenten eines Kraftfahrzeugs sind für einen Betrieb an einem 12 V Bordnetz ausgelegt. Sowohl bei Halbleiterelektronik, als auch bei Leuchtmitteln sind zukünftig eher niedrigere Betriebsspannungen zu erwarten, so das mittelfristig ein weiteres Absenken der Bordnetzspannung möglich ist. Zugleich ist zum Betrieb von Elektromotoren und Startergeneratoren eine höhere Betriebsspannung, beispielsweise 48 V, vorteilhaft. Damit ist es vorteilhaft, einen Niederspannungsenergiespeicher als Energiespeicher zur Versorgung eines Niederspannungsbordnetzes und einen Höherspannungsenergiespeicher zum Betrieb eines Höherspannungsbordnetzes zu nutzen.

Selbstverständlich ist es auch möglich, dass das erfindungsgemäße Verfahren in Kraftfahrzeugen mit mehr als zwei getrennten Bordnetzen mit zugeordneten Energiespeichern genutzt wird. In diesem Fall kann das Verfahren zum Testen mehrerer Energiespeicher, insbesondere derer, die keinen Strom zum Starten und/oder Betrieb eines Motors, der dem Fahrbetrieb dient, zur Verfügung stellen, genutzt werden.

Es ist vorteilhaft, wenn die Schritte vor Fahrtbeginn, insbesondere beim Einschalten der Zündung des Kraftfahrzeugs, beim öffnen einer Fahrzeugtür und/oder bei Erkennung eines zum Fahrzeug gehörenden Funkschlüssels in einer vorgegebenen Maximalentfernung durch eine Detektionseinrichtung, und/oder in regelmäßigen Abständen, insbesondere bei Betrieb des Kraftfahrzeugs oder bei stillgelegtem Kraftfahrzeug durchgeführt werden.. Ein Durchführen der Schritte des erfindungsgemäßen Verfahrens beim Einschalten der Zündung des Kraftfahrzeugs entspricht im Wesentlichen dem unvermeidbaren Testen eines Energiespeichers in einem konventionellen Kraftfahrzeug beim Anlassen des Kraftfahrzeugs. Es wird also ein gleiches Maß an Betriebssicherheit hergestellt, wie es bei einem konventionellen Kraftfahrzeug der Fall ist. Um eine Verzögerung des Fahrtantritts durch das Testverfahren zu vermeiden kann es vorteilhaft sein, das Testverfahren bereits vor dem Einschalten der Zündung durchzuführen. Es kann also zu Zeiten erfolgen, bei denen ein zukünftiger Start des Kraftfahrzeugs wahrscheinlich erscheint, also beispielsweise bereits bei Öffnen der Fahrertür bzw. dem Aufsperren des Kraftfahrzeugs, oder bei Annährung des Fahrers. Die Annährung des Fahrers kann beispielsweise durch eine Entfernungsbestimmung oder Detektion eines Funkschlüssels, beispielsweise durch Messung der Signalintensität erfolgen.

Werden erste Energiespeicher genutzt, bei denen eine häufige starke Belastung nicht schädlich für die Lebenszeit des ersten Energiespeichers ist, ist es jedoch vorteilhaft, die Schritte des erfindungsgemäßen Verfahrens in regelmäßigen Abständen durchzuführen. So kann ein solcher Test beispielsweise alle 10 oder alle 50 Fahrkilometer durchgeführt werden, oder beispielsweise einmal pro Stunde Fahrzeit des Kraftfahrzeugs. Alternativ oder ergänzend kann ein solcher Test auch in bestimmten Fahr- oder Benutzungssituationen des Kraftfahrzeugs durchgeführt werden. So ist es beispielsweise möglich, einen solchen Test vor Benutzung eines Entertainmentsystems, das große Energiemengen benötigt, durchzuführen. Auch eine Durchführung eines Tests des ersten Energiespeichers bei Überschreiten einer gewissen Geschwindigkeit ist möglich. Damit ist insbesondere bei schneller Fahrt eine Funktion aller Fahrzeugsysteme gewährleistet. Auch ein Test in festen Intervallen bei Stillstand des Kraftfahrzeugs ist möglich. Zumindest eine Steuereinrichtung eines modernen Kraftfahrzeugs ist häufig auch bei abgestelltem Kraftfahrzeug aktiv. Dies kann genutzt werden, um auch im abgestellten Zustand das Testverfahren regelmäßig, beispielsweise alle 24 Stunden, durchzuführen. Dies kann insbesondere bei Überschreiten einer gewissen Mindeststandzeit erfolgen.

Es ist vorteilhaft, wenn der Verbraucher ein bidirektionaler DC/DC-Wandler des Kraftfahrzeugs ist. Viele Hybridkraftfahrzeuge weisen ohnehin einen bidirektionalen DC/DC-Wandler auf, da in diesem Fall sowohl eine Speisung des Niederspannungsnetzes aus dem Höherspannungsnetz als auch eine Speisung des Höherspannungsnetzes aus dem Niederspannungsnetz möglich ist. Die Speisung des Niederspannungsnetzes aus dem Höherspannungsnetz ist vorteilhaft, da in diesem Fall auf eine separate Lichtmaschine zum Laden der Niederspannungsenergiespeichereinheit und zum Betrieb der durch das Niederspannungsnetz versorgten Fahrzeugsysteme verzichtet werden kann. Das Laden des Niederspannungsenergiespeichers des Kraftfahrzeugs erfolgt in diesem Fall ausschließlich durch den Betrieb des oder eines der Elektromotoren als Generator. Die Speisung des Höherspannungsnetzes aus dem Niederspannungsnetz im Kraftfahrzeug ist meist vor allem vorgesehen, um eine Starthilfe des Kraftfahrzeugs durch ein weiteres Kraftfahrzeug, das ausschließlich ein Niederspannungsnetz aufweist, zu ermöglichen.

Für das erfindungsgemäße Verfahren ist es wesentlich, dass der DC/DC-Wandler so betrieben werden kann, dass Energie dem ersten Spannungsnetz, das den ersten Energiespeicher umfasst, entnommen und in das zweite Spannungsnetz, das den zweiten Energiespeicher umfasst, transportiert werden kann. Hierzu wird, beispielsweise bei vorliegen eines Höher- und eines Niederspannungsnetzes, der DC/DC-Wandler so betrieben, dass die Spannung auf der Höherspannungsseite des DC/DC-Wandlers höher ist als die am Höherspannungsenergiespeicher abfallende Spannung. Je nach Aufbau des DC/DC-Wandlers kann die ausgegebene Spannung unterschiedlich angepasst werden. Im einfachsten Fall kann der Wandlungsfaktor des DC/DC-Wandlers direkt, beispielsweise durch Pulsbreitenmodulation des Ansteuersignals, angepasst werden. Meist werden DC/DC-Konverter aber geregelt betrieben. In diesem Fall erfolgt eine Steuerung über einen Regelkreis. Mit einer solchen Regelung wird eine stabile Ausgangsspannung bei Änderungen der Belastung oder der Eingangsspannung erreicht.

Im Schritt des Verbindens des ersten Energiespeichers mit dem Verbraucher kann zunächst eine Referenzspannung oder ein Referenzstrom des DC/DC-Konverters angepasst und der DC/DC-Konverter anschließend für die Länge des Zeitintervalls mit der angepassten Referenzspannung bzw. dem angepassten Referenzstrom betrieben werden. Im Regelfall wird der DC/DC-Konverter in einem Hybridfahrzeug so betrieben, dass ein Niederspannungsenergiespeicher aus dem Höherspannungsnetz geladen wird. Um nun den Niederspannungsenergiespeicher kurzzeitig mit einem Verbraucher mit niedriger Impedanz zu belasten ist es möglich, die Referenzspannung bzw. den Referenzstrom an einem geregelten DC/DC-Konverter so anzupassen, dass die Ausgangsspannung des DC/DC-Konverters kurzzeitig wesentlich höher eingestellt wird als die am Höherspannungsenergiespeicher abfallende Spannung. In diesem Fall wird elektrische Energie vom Niederspannungsnetz in das Höherspannungsnetz transportiert und die transportierte Energie entstammt dem Niederspannungsenergiespeicher. Der Niederspannungsenergiespeicher wird also entladen. Der DC/DC-Konverter selbst hat einen sehr niedrigen Widerstand. Da eine Konvertierung der Spannungen auf höhere Spannungen als die Spannung, die an dem Höherspannungsenergiespeicher abfällt, erfolgt, wird der Höherspannungsenergiespeicher geladen und ist daher ein Verbraucher. Der Innenwiderstand des Höherspannungsenergiespeichers ist in der Regel nied-rig. Für den Stromfluss des Niederspannungsenergiespeichers scheint dieser Widerstand noch niedriger, da die Spannung zuvor durch den DC/DC-Konverter erhöht wird. Im beschriebenen Betriebsmodus dient der DC/DC-Konverter also insgesamt als ein niederohmiger Verbraucher für den ersten Energiespeicher.

Um kurze Zeitintervalle zu erreichen kann es vorteilhaft sein, den DC/DC-Konverter vor Anpassung der Referenzspannung bzw. des Referenzstroms von dem ersten und/oder dem zweiten Energiespeicher zu trennen bzw. den Betrieb des DC/DC-Konverters zu unterbrechen. In diesem Fall wird der Betrieb des DC/DC-Konverters, falls er im Betrieb ist, zunächst unterbrochen, dann werden Referenzspannung bzw. Referenzstrom angepasst, und dann der Betrieb des DC/DC-Konverters wieder aufgenommen.

Es ist vorteilhaft, wenn der im Zeitintervall vom Verbraucher abgegebene Strom zum Laden des zweiten Energiespeichers genutzt wird oder der Verbraucher ein Motor, ein Startgenerator oder eine Heizeinrichtung ist. Wird der zweite Energiespeicher geladen, kann das erfindungsgemäße Verfahren nahezu ohne Energieverlust abgeführt werden. Ein Laden des Höherspannungsenergieträgers durch den Verbraucher ist insbesondere dann möglich, wenn der Verbraucher wie oben beschrieben ein DC/DC-Konverter ist. Alternativ kann das Laden jedoch auch durch einen Motor als Verbraucher und einen nachgeschalteten Generator oder Ähnliches erfolgen. Insbesondere kann bei Verbrauch des Stroms an einem Motor auch Verbrauch bei stillstand des Motors, beispielsweise durch das Kurzschließen von Motorwicklungen erfolgen. Der Strom kann auch als Heizleistung verbraucht werden. Es ist vorteilhaft, wenn dies an einer Heizeinrichtung des Kraftfahrzeugs erfolgt.

Ist die Induktivität des Verbrauchers oder des ersten Energiespeichers nicht zu hoch, wird nahezu sofort mit dem Verbinden des ersten Energiespeichers mit dem Verbraucher ein sehr hoher Stromfluss aus dem ersten Energiespeicher durch den Verbraucher erreicht. Sobald sich also nach dem Verbinden die am ersten Energiespeicher abfallende Spannung stabilisiert hat, bringen weitere Spannungsmessungen keine weiteren Informationen. Das Zeitintervall sollte also so begrenzt sein, dass eine Stabilisierung der Ausgangsspannung des ersten Energiespeichers nach dem Verbinden möglich ist, dann sollte mindestens eine Messung durchgeführt werden, wobei weitere Messungen ausschließlich zur Reduzierung des Rauschens dienen, und anschließend kann der Verbraucher wieder vom ersten Energiespeicher getrennt werden. Daher ist es vorteilhaft, wenn das Zeitintervall zwischen 2 ms und 60 s, insbesondere zwischen 200 ms und 40 s, speziell zwischen 1 s und 30 s liegt. Sollte sich die Stabilisierungszeit der am ersten Energiespeicher abfallenden Spannung nach dem Verbinden abhängig von einem oder mehreren Parametern stark ändern, kann es vorteilhaft sein, nach dem Verbinden die abfallende Spannung kontinuierlich zu messen und als Endbedingung des Zeitintervalls eine Stabilisierung der Spannung, also beispielsweise einen Maximalabstand von zwei aufeinander folgenden Spannungen oder ein maximales Intervall für mehrere aufeinander folgende Spannungen festzulegen.

Es ist möglich, dass Impedanz des Verbrauchers so gewählt wird, dass der im Zeitintervall abgegebene Strom bei einem funktionsfähigen ersten Energiespeicher, bei dem kein Signal ausgegeben wird, einen Maximalstromstärke von wenigstens 40 A, vorzugsweise wenigstens 200 A, im Speziellen wenigstens 300 A erreicht. Beim Anlassen eines konventionellen Kraftfahrzeugs werden vom Energiespeicher des Kraftfahrzeugs Ströme von bis zu 700 A abgegeben. Bei konventionellen Kraftfahrzeugen wird der Energiespeicher, in der Regel ein Bleiakkumulator, also mit sehr hohen Strömen getestet. Soll kein Anlasser durch den ersten Energiespeicher betrieben werden, ist es im normalen Fahrbetrieb häufig nicht notwendig, dass so hohe Ströme zur Verfügung gestellt werden. Dennoch kann es vorteilhaft sein, den ersten Ergiespeicher mit einer Maximalstromstärke zu belasten, die weit oberhalb der im Fahrbetrieb maximal genutzten Maximalstromstärke liegt. Durch eine Wahl eines passenden Verbrauchers bzw. durch eine passende Ansteuerung eines DC/DC-Konverters kann eine optimale kleinste Maximalstromstärke gewählt werden.

Bei Gabe eines Signals durch die Steuereinrichtung kann ein Warnsignal durch eine Hinweiseinrichtung des Kraftfahrzeugs, insbesondere als akustische, optische oder haptische Benachrichtigung, an den Fahrer ausgegeben werden. Während ein nicht Bestehen des erfindungsgemäßen Testverfahrens zunächst einen Betrieb des Kraftfahrzeugs nicht verhindert ist es dennoch wichtig, einen Fahrer über dieses nicht Bestehen des Testes zu informieren. Es ist möglich, dass eine solche Benachrichtigung optisch also beispielsweise durch eine Warnleuchte am Armaturenbrett erfolgt. Warnleuchten am Armaturenbrett werden von einigen Fahrern jedoch nicht ausreichend beachtet. Darum kann alternativ oder zusätzlich auch eine akustische Warnung, beispielsweise ein Summen, ein regelmäßiges Piepen oder Ähnliches ausgegeben werden oder der Fahrer kann haptisch, beispielsweise durch ein Vibrieren des Lenkrads oder Ähnliches darauf hingewiesen werden, dass ein zuverlässiger Betrieb aller Fahrzeugsysteme mit dem momentanen Zustand des ersten Ergiespeichers nicht sichergestellt werden kann.

In einigen Kraftfahrzeugen ist es möglich, dass ein sicherer Fahrbetrieb bei einem nicht ausreichend leistungsfähigen ersten Energiespeicher nicht sichergestellt werden kann. Deshalb kann alternativ oder zusätzlich bei Gabe eines Signals durch die Steuereinrichtung das Kraftfahrzeug stillgelegt wird, wobei dies insbesondere bei Stillstand des Kraftfahrzeugs erfolgt.

Es ist auch möglich, dass bei Gabe eines Signals durch die Steuereinrichtung die Nutzung mindestens eines Fahrzeugsystems, insbesondere eines Kommunikations-, Unterhaltungs-, Fahrassistenz-, Sensor-, Heiz- oder Klimatisierungssystems und/oder Navigationssystems, unterbunden wird. Dies ist insbesondere vorteilhaft, da selbst ein erster Energiespeicher, der nicht ausreichend Leistungsfähig für einen ungestörten Betrieb aller Fahrzeugsysteme des Kraftfahrzeugs ist, häufig dennoch ausreichend Leistungsfähig ist, die sicherheitsrelevanten Systeme des Kraftfahrzeugs zu betreiben, wenn eine Nutzung zusätzlicher Funktionen unterbunden wird bzw. diese Systeme vom Bordnetzgetrennt werden.

Zudem oder alternativ kann bei Gabe eines Signals durch die Steuereinrichtung der erste Energiespeicher vom Bordnetz des Kraftfahrzeugs getrennt werden. Damit kann beispielsweise ein Tiefentladen des Energiespeichers vermieden werden.

Es ist auch möglich, dass nach Gabe eines Signals durch die Steuereinrichtung ein Wechsel in einen Betriebsmodus des Kraftfahrzeugs mit rein elektrischem Fahrbetrieb unterbunden wird und/oder ein solcher Betriebsmodus verlassen wird. In vielen Fahrzeugen wird dadurch zunächst der zweite Energiespeicher entlastet. Dies erlaubt es beispielsweise die durch Generatoren im Kraftfahrzeug gewonnene Energie dem ersten Energiespeicher zuzuführen oder den ersten Energiespeicher durch den zweiten Energiespeicher zu laden bzw. schneller zu laden.

Des Weiteren betrifft die Erfindung ein Kraftfahrzeug umfassend einen ersten Energiespeicher zum Betrieb mehrerer Fahrzeugsysteme und einen zweiten Energiespeicher, der zumindest die zum Starten des Kraftfahrzeugs benötigte elektrische Energie zur Verfügung stellt, eine Spannungsmesseinrichtung, mindestens sowie eine Steuereinrichtung, wobei das Kraftfahrzeug zur Durchführung eines obig beschriebenen Verfahrens ausgebildet ist. Hierfür ist es notwendig, dass das Fahrzeug einen Verbraucher mit niedriger Impedanz aufweist, wobei die Steuereinrichtung derart ausgebildet ist, dass sie zur Durchführung des Verfahrens diesen Verbraucher mit dem ersten Energiespeicher verbinden kann.

Insbesondere kann die Steuereinrichtung zur Bestimmung einer Untergrenze der am ersten Energiespeicher abfallenden Spannung, zum Auslesen der durch die Spannungsmessungseinrichtung gemessenen Spannung und zur Gabe eines Alarmsignals, wenn die eine gemessene Spannung niedriger als die Untergrenze ist, ausgebildet sein. Über die festgelegte Untergrenze der Spannung wird wie bereits beschrieben der maximale Innenwiderstand des ersten Energiespeichers festgelegt, bei dem noch kein Alarm ausgegeben wird. Die Steuereinrichtung kann, falls die Spannungsmesseinrichtung die Spannung am ersten Energiespeicher periodisch ausliest, schlicht den letzten ausgelesenen Wert aus einem Puffer abholen. Alternativ ist es möglich, dass die Steuereinrichtung die Spannungsmesseinrichtung derart ansteuern kann, dass sie eine Messung der am ersten Energiespeicher abfallenden Spannung durchführt. Es ist vorteilhaft, wenn die Steuereinrichtung derart ausgebildet ist, dass die am ersten Energiespeicher abfallende Spannung jederzeit, das heißt auch außerhalb des Verfahrens zum Testen des ersten Energiespeichers ausgelesen werden kann. Damit kann eine Verringerung der Spannung am ersten Energiespeicher und damit eine Verringerung der Leistungsfähigkeit in vielen Fällen bereits ohne Last bzw. bei der Last, die im normalen Betrieb vom Bordnetz erzeugt wird, festgestellt werden. Es ist beispielsweise möglich, dass die gleiche Warnleuchte, die aktiviert wird, wenn ein Abfallen der Batteriespannung unter eine erste Spannungsgrenze bei einer Belastung mit einem Verbraucher mit niedriger Impedanz festgestellt wird, auch dann aktiviert wird, wenn im normalen Betrieb die Spannung unter einen zweiten Grenzwert fällt.

Zudem kann die Steuereinrichtung oder eine weitere Steuereinrichtung zur Verbindung des ersten Energiespeichers mit einem Verbraucher niedrigerer Impedanz als die minimale Gesamtimpedanz einer Parallelschaltung einer festgelegten Auswahl der Fahrzeugsysteme und zur Auswertung des Alarmsignals ausgebildet sein. Die Steuereinrichtung kann beispielsweise einen Schalter steuern, der den Verbraucher mit dem ersten Energiespeicher verbindet. Der Verbraucher kann jedoch auch eine Einrichtung sein, deren Verbrauch durch die Steuereinrichtung steuerbar ist. In diesem Fall kann zur Durchführung des Testverfahrens der Verbrauch des Verbrauchers erhöht werden.

Werden zwei getrennte Steuereinrichtungen genutzt, so kann die Steuereinrichtung, die den ersten Energiespeicher mit dem Verbraucher verbindet und diese Verbindung auch wieder trennt, auch dazu ausgebildet sein, das Alarmsignal, das von der Steuereinrichtung, die eine Überwachung des ersten Energiespeichers durchführt, zu empfangen und abhängig von diesem Signal ein weiteres Signal ausgeben oder direkt ein Anzeigeelement oder andere Elemente zur Informationsausgabe ansteuern.

Es ist besonders vorteilhaft, wenn der Verbraucher ein DC/DC-Konverter ist und die Steuereinrichtung, die weitere Steuereinrichtung oder eine dritte Steuereinrichtung zur Vorgabe des Sollstroms oder der Sollspannung des DC/DC-Konverters ausgebildet ist. Wie oben beschrieben, kann durch Veränderung des Sollstroms oder der Sollspannung eines DC/DC-Konverters ein DC/DC-Konverter, insbesondere ein bidirektionaler DC/DC-Konverter, der im Normalbetrieb zum Laden des ersten Energiespeichers genutzt wird, als ein Verbraucher mit niedriger Impedanz dienen. Dies ist insbesondere vorteilhaft, da dann mit der abgegebenen Energie des ersten Energiespeichers der zweite Energiespeicher geladen werden kann und daher nur minimale Energieverluste auftreten.

Wird ein DC/DC-Konverter, der einen zweiten Energiespeicher lädt, als Verbraucher für den ersten Energiespeicher genutzt, so ist kein gesondertes Bauteil als Verbraucher notwendig. Da große Teile der vom Niederspannungsenergiespeicher abgegebenen Energie im zweiten Energiespeicher gespeichert werden können, wird auch wenig Verlustleistung abgegeben. Damit wird keine zusätzliche Abwärme erzeugt und es ist auch keine zusätzliche Kühlung des Verbrauchers notwendig.

Das Kraftfahrzeug kann beispielsweise so ausgebildet sein, dass die erste Steuereinrichtung ein Niederspannungsenergiemanagement ist, das das Niederspannungsnetz des Kraftfahrzeugs überwacht und unter anderem stetig und in regelmäßigen Abständen die am ersten Energiespeicher abfallende Spannung misst. Ein solches Niederspanngsenergiemanagement kann derart ausgebildet sein, dass bei Unterschreiten einer oder mehrerer gespeicherter Spannungsuntergrenzen Signale an weitere Komponenten gesandt werden. Eine weitere Steuereinrichtung kann als Höherspannungskoordinator dienen, der beispielsweise den DC/DC-Konverter ein- und ausschalten kann bzw. ihn mit den Energiespeichern verbinden bzw. von diesen trennen kann. Des Weiteren empfängt dieser Höherspannungskoordinator die Signale des Niederspannungsenergiemanagements und kann daher bei Unterschreiten der vorgegebenen Spannungsgrenze über ein Cockpitinstrument eine Warnung an den Fahrer ausgeben.

Als dritte Steuereinrichtung kann ein Höherspannungskoordinator dienen, der die Spannung im Höherspannungsnetz des Kraftfahrzeugs überwacht und regelt. Der Höherspannungskoordinator kann dazu ausgebildet sein, die Sollspannung bzw. den Sollstrom des DC/DC-Konverters anzupassen.

In einem solchen Kraftfahrzeug kann das erfindungsgemäße Verfahren also durch den Höherspannungskoordinator durchgeführt werden, der die dem Höherspannungsenergiemanagement und dem Niederspannungsenergiemanagement zugeordneten Steuereinrichtungen steuert und deren Signale empfangen kann.

Selbstverständlich kann das Kraftfahrzeug beliebig viele Steuereinrichtungen aufweisen, die genutzt werden können um das erfindungsgemäße Verfahren durchzuführen. Das Kraftfahrzeug kann auch beliebig viele Bordnetze mit beliebig vielen zugeordneten Energiespeichern aufweisen, wobei es möglich ist, dass das Kraftfahrzeug eine oder mehrere Steuereinrichtungen, die zur Durchführung des erfindungsgemäßen Verfahrens zum Test mehrerer oder aller dieser Energiespeicher ausgebildet ist bzw. sind, umfasst.

Weitere Vorteile und Einzelheiten der Erfindung ergeben sich aus den folgenden Ausführungsbeispielen und Zeichnungen. Dabei zeigen:
- Fig. 1: ein Ablaufdiagramm eines Ausführungsbeispiels des erfindungsgemäßen Verfahrens,
- Fig. 2: ein Ablaufdiagramm eines weiteren Ausführungsbeispiels des erfindungsgemäßen Verfahrens,
- Fig. 3: ein erfindungsgemäßes Kraftfahrzeug, und
- Fig. 4: eine schematische Darstellung des Höher- und des Niederspannungsnetzes des erfindungsgemäßen Kraftfahrzeugs.

In den folgenden Ausführungsbeispielen wird, im Sinne einer bessern Verständlichkeit, davon Ausgegangen, dass der erste Energiespeicher ein Niederspannungsenergiespeicher und der zweite Energiespeicher ein Höherspannungsenergiespeicher ist und dass als Signal ein Warnsignal an den Fahrer ausgegeben wird. Dem Fachmann erschließt sich selbstverständlich, dass auch Energiespeicher mit gleicher Nennspannung genutzt werden können, bzw. dass der erste Energiespeicher auch eine höhere Nennspannung aufweisen kann als der zweite Energiespeicher und dass das Signal auch weitere oder alternative Funktionen im Kraftfahrzeug auslösen kann.

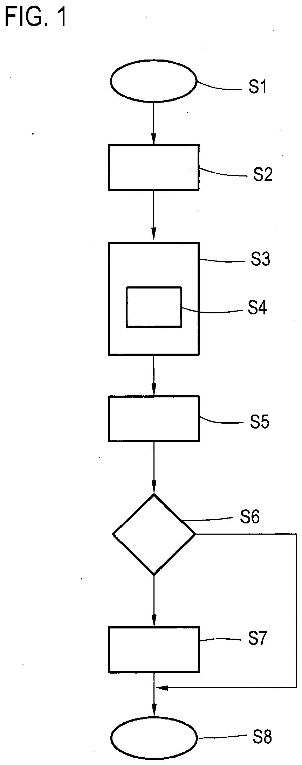

Fig. 1 zeigt ein Ablaufdiagramm eines Verfahrens zum Testen eines Niederspannungsenergiespeichers. Das Verfahren wird in Schritt S1, beispielsweise durch das Einschalten des Zündschlosses gestartet. In Schritt S2 wird ein Verbraucher mit niedriger Impedanz mit dem Niederspannungsenergiespeicher verbunden. Die Verbindung erfolgt beispielsweise durch das Schließen eines Schalters durch eine Steuereinrichtung. Aufgrund der Verbindung mit einem Verbraucher mit einer niedrigen Impedanz werden vom Niederspannungsenergiespeicher große Ströme abgegeben. Mit zunehmender abgegebener Stromstärke nimmt die Wichtigkeit des inneren Widerstands des Niederspannungsenergiespeichers zu. Dies kann zu einem Absenken der Spannung führen, was im Schritt S4, dem Messen der Spannung, festgestellt werden kann. Nach Schritt S2 beginnt in Schritt S3 ein Warteintervall. Die Länge des Warteintervalls S3 kann beispielsweise durch einen digitalen Timer festgelegt werden. Alternativ ist aber auch eine analoge Schaltung möglich, die beispielsweise einen Schalter nur für einen sehr kurzen Zeitraum schließt. Das Warteintervall ist im erfindungsgemäßen Verfahren hinreichend lange gewählt, dass eine Messung erst zu dem Zeitpunkt stattfindet, an dem sich die im Niederspannungsenergiespeicher abfallende Spannung stabilisiert hat. Längere Stabilisierungsintervalle sind beispielsweise dann notwendig, wenn die innere Impedanz des Niederspannungsenergiespeichers oder die Impedanz des Verbrauchers hohe induktive oder kapazitive Anteile aufweisen.

Wird beispielsweise ein Bleiakkumulator, wie er in den meisten Fahrzeugen mit Verbrennungsmotor zum Einsatz kommt, als Niederspannungsenergiespeicher genutzt und die Impedanz des Verbrauchers ist ungefähr so gewählt, dass Ströme wie beim Anlassen eines Fahrzeugs mit Verbrennungsmotor fließen, so kann dieser Verbrauch eine oder mehrere Sekunden lang aufrechterhalten werden, ohne dass dieser Verbrauch dem Niederspannungsenergiespeicher schadet. Typischerweise sind jedoch wesentliche kürzere Zeiträume von wenigen ms oder sogar unterhalb 1 ms ausreichend. Nach einem ausreichend langen Warteintervall wird innerhalb des Schrittes S3, also während gewartet wird, in Schritt S4 durch die Spannungsmesseinrichtung mindestens ein Messwert aufgenommen.

Die Spannungsmesseinrichtung kann derart ausgebildet sein, dass sie die am Niederspannungsenergiespeicher abfallende Spannung kontinuierlich misst. Ist die Messfrequenz ausreichend hoch, dass mehrere Messwerte innerhalb des Warteintervalls S3 aufgenommen werden, so reicht es in Schritt S4 dem letzten oder die letzten Messwerte aus einem Messpuffer auszulesen. Ist dies nicht der Fall, kann aber durch die Steuereinrichtung auch gezielt eine Spannungsmessung durch die Spannungsmesseinrichtung ausgelöst werden. Die Messung mehrerer Spannungen im Schritt S4 kann vorteilhaft sein, um nach Mittelung mehrerer Messwerte einen Gesamtmesswert mit kleinerem Fehler zu erhalten. Die Messung mehrerer Werte im Schritt S4 kann jedoch auch genutzt werden, um sicherzustellen, dass die am Niederspannungsenergiespeicher abfallende Spannung stabil ist, das heißt nicht mehr schwingt, was bei plötzlichem Zuschalten eines Verbrauchers der Fall sein kann. Zur Diagnose eines Niederspannungsenergiespeichers kann es auch vorteilhaft sein, einen zeitlichen Verlauf der am Niederspannungsenergiespeicher abfallenden Spannung während der Verbindung mit dem Verbraucher mit niedriger Impedanz aufzuzeichnen. Zum reinen Testen des Niederspannungsenergiespeichers ist dies jedoch in der Regel nicht notwendig.

Nach Aufnahme des oder aller Messwerte im Schritt S4 kann nach Beendigung des Warteintervalls S3 die Verbindung des Niederspannungsenergiespeichers mit dem Verbraucher in Schritt S5 getrennt werden. Die Verbindung des Verbrauchers mit niedriger Impedanz mit dem Niederspannungsenergiespeicher führt zu großen Stromflüssen und damit zu einer schnellen Entladung des Niederspannungsenergiespeichers sowie zu einer Erwärmung des Niederspannungsenergiespeichers, der Leitungen sowie weiterer beteiligter Komponenten. Daher sollte die Verbindung im Schritt S5 wieder getrennt werden, sobald sie nicht mehr notwendig ist.

Die folgenden Schritte dienen nur noch der Auswertung des Messergebnisses. Diese können potentiell schon vor dem Schritt S5 durchgeführt werden, wie beschrieben ist es jedoch vorteilhaft, Schritt S5 so früh wie möglich durchzuführen. Im Schritt S6 wird die in Schritt S4 gemessene Spannung mit einem Mindestwert der Spannung verglichen. Wie bereits beschrieben ist die Spannung im Wesentlichen abhängig vom Innenwiderstand des Niederspannungsenergiespeichers. Ein hoher Innenwiderstand des Niederspannungsenergiespeichers kann darauf hinweisen, dass der Ladezustand des Niederspannungsenergiespeichers niedrig ist, oder dass der Niederspannungsenergiespeicher andere Mängel aufweist, die die Leistungsfähigkeit senken. Liegt der gemessene Spannungswert oberhalb eines Spannungsgrenzwertes kann davon ausgegangen werden, dass der Niederspannungsenergiespeicher ausreichend leistungsfähig für den Fahrbetrieb ist und das Verfahren wird in Schritt S8 beendet. Liegt die gemessene Spannung jedoch unterhalb des vorgegebenen Grenzwertes, so wird in Schritt S7 ein Signal an den Fahrer ausgegeben, um ihn zu informieren, dass der Zustand des Niederspannungsenergiespeichers nicht gut genug ist, um ein zuverlässiges Funktionieren aller Fahrzeugsysteme im Fahrzeugbetrieb sicherzustellen.

Es sei darauf hingewiesen, dass in Schritt S6 auch mehrere Grenzwerte genutzt werden können und je nach festgelegtem Spannungsgrenzwert, der unterschritten wird, unterschiedliche Reaktionen erfolgen können. So kann ein leichtes Unterschreiten der Spannung im Schritt S6 ausschließlich zur Anzeige eines Warnsymbols im Sichtbereich des Fahrers in Schritt S7 führen. Ein Unterschreiten eines weiteren Grenzwertes kann dann zur Gabe eines haptischen oder akustischen Signals führen. Auch können bei Unterschreiten von Spannungsgrenzwerten in Schritt S6 einzelne Fahrzeugsysteme, die nicht sicherheitsrelevant sind, insbesondere reine Unterhaltungssysteme, stillgelegt werden. Wird das Verfahren bei Fahrtantritt durchgeführt, kann bei Unterschreiten eines bestimmten Spannungsgrenzwertes auch eine Fahrt mit dem Kraftfahrzeug, beispielsweise durch Stilllegen des Motors, oder eine Fahrt mit rein elektrischem Antrieb verhindert werden.

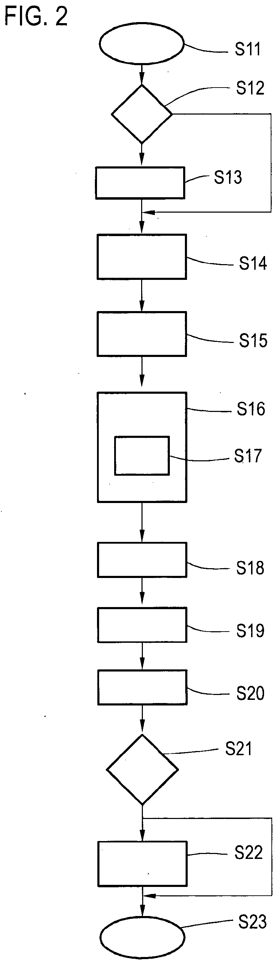

Fig. 2 zeigt ein Ablaufdiagramm eines Verfahrens zum Testen eines Niederspannungsenergiespeichers, wobei hier als Verbraucher ein DC/DC-Konverter genutzt wird. Nach dem Start des Verfahrens in Schritt S11 wird in Schritt S12 überprüft, ob der DC/DC-Konverter aktiv ist. Abhängig von der Bauart des DC/DC-Konverters kann dieser immer aktiv sein, wenn er mit beiden Spannungsnetzen, dem Niederspannungsnetz und dem Höherspannungsnetz, des Kraftfahrzeugs verbunden ist. Es ist aber auch möglich, dass der DC/DC-Konverter nur dann aktiv ist, das heißt Strom von einem in das andere Netz leiten kann, wenn er mit gewissen Steuersignalen angesteuert wird. Falls der DC/DC-Konverter aktiv ist, wird er daraufhin in Schritt S13 deaktiviert bzw. von einem oder beiden Netzen getrennt. Der DC/DC-Konverter soll im Verfahren zwar als Verbraucher dienen, um eine möglichst kurze Dauer des Testverfahrens zu erreichen, kann es aber vorteilhaft sein, den DC/DC-Konverter zunächst von den Netzen zu trennen und ihn später nur für das Zeitintervall, in dem er als Verbrauch dienen soll, mit den Netzen zu verbinden.

Nachdem in Schritt S12 festgestellt wurde, dass der DC/DC-Konverter nicht aktiv ist oder er in Schritt S13 deaktiviert wurde, wird in Schritt S14 der Spannungs- oder Stromsollwert des geregelten DC/DC-Konverters auf einen neuen Wert gesetzt. Der DC/DC-Konverter in Hybridfahrzeugen ist im normalen Fahrbetrieb in der Regel so konfiguriert, dass Strom aus dem Höherspannungsnetz ins Niederspannungsnetz geleitet wird, um die Niederspannungskomponenten des Kraftfahrzeugs zu betreiben und den Niederspannungsenergiespeicher zu laden. Wie eingangs erwähnt, kommen in Hybridfahrzeugen häufig bidirektionale DC/DC-Konverter zum Einsatz, die es auch erlauben, beispielsweise zum Zweck der Starthilfe, Strom vom Niederspannungsnetz in das Höherspannungsnetz zu leiten. Die Richtung der Stromleitung ist bei geregelten Konvertern durch eine Anpassung der Spannungs- bzw. Stromsollwerte erreichbar. Hier ist zu beachten, dass auch bei stromgeregelten DC/DC-Reglern der Sollwert die Ausgangsspannung des DC/DC-Reglers vorgibt. Unabhängig davon, ob der DC/DC-Regler spannungs- oder stromgeregelt ist, kann damit über eine Sollgröße die Sollausgangsspannung gesteuert werden. Ist die Sollausgangsspannung kleiner als die von außen am DC/DC-Konverter anliegende Spannung, also in der Regel als die Spannung, die an dem Höherspannungsenergiespeicher abfällt, so fließt Strom vom Höherspannungskreis in den Niederspannungskreis, womit der Niederspannungsenergiespeicher geladen wird. Dies ist der Bereich, in dem der DC/DC-Konverter im Betrieb des Kraftfahrzeugs meist betrieben wird. Wird hingegen der Sollwert so weit erhöht, dass die Spannung auf der Höherspannungsseite des DC/DC-Konverters höher ist als die Spannung, die am Höherspannungsenergiespeicher abfällt, so wird der Höherspannungsenergiespeicher geladen und die notwendige Energie wird dem Niederspannungsnetz, also dem Niederspannungsenergiespeicher entnommen.

Zu Testzwecken sollen dem Niederspannungsenergiespeicher große Strommengen entnommen werden. Daher wird im Schritt S14 der Sollwert des DC/DC-Konverters so eingestellt, dass die Ausgangsspannung des DC/DC-Konverters deutlich oberhalb der am Höherspannungsenergiespeicher abfallenden Spannung liegt. Im Schritt S15 wird anschließend der DC/DC-Konverter aktiviert bzw. mit den beiden Spannungsnetzen verbunden. Der DC/DC-Konverter transportiert somit wie oben beschrieben Energie aus dem Niederspannungsenergiespeicher in den Höherspannungsenergiespeicher, das heißt, der DC/DC-Konverter dient im Niederspannungskreis als Verbraucher. Abhängig von der Einstellung des Sollwerts in Schritt S14 kann dem Niederspannungsenergiespeicher nach dem Verbinden in Schritt S15 leicht ein Storm von einigen 10 bis einigen 100 A entnommen werden. Die Schritte S16, S17 und S18 entsprechenden den Schritten S3, S4 und S5 der Fig. 1. In Schritt S16 wird nach dem Verbinden ein gewisses Warteintervall abgewartet, in dem in Schritt S17 einer oder mehrere Spannungswerte durch die Spannungsmesseinrichtung aufgenommen werden. In Schritt S18 wird der DC/DC-Konverter wieder deaktiviert bzw. von mindestens einem der Netze getrennt. Da der DC/DC-Konverter außerhalb des Testintervalls für seine normalen Aufgaben zur Verfügung stehen soll, wird im Schritt S19 der Sollwert wieder auf einen ursprünglichen Wert zurückgesetzt, der üblicherweise einem langsamen Laden des Niederspannungsenergiespeichers aus dem Höherspannungsenergiespeicher bzw. dem restlichen Höherspannungsnetz entspricht. Anschließend wird der DC/DC-Konverter in Schritt S20 wieder aktiviert bzw. mit den Netzen verbunden. Der Vergleich der Spannung mit einem Mindestwert in Schritt S21 sowie die Signalgabe in Schritt S22 und das Ende des Verfahrens in Schritt S23 entsprechen wiederum den entsprechenden Schritten S6, S7 und S8 der Fig. 1.

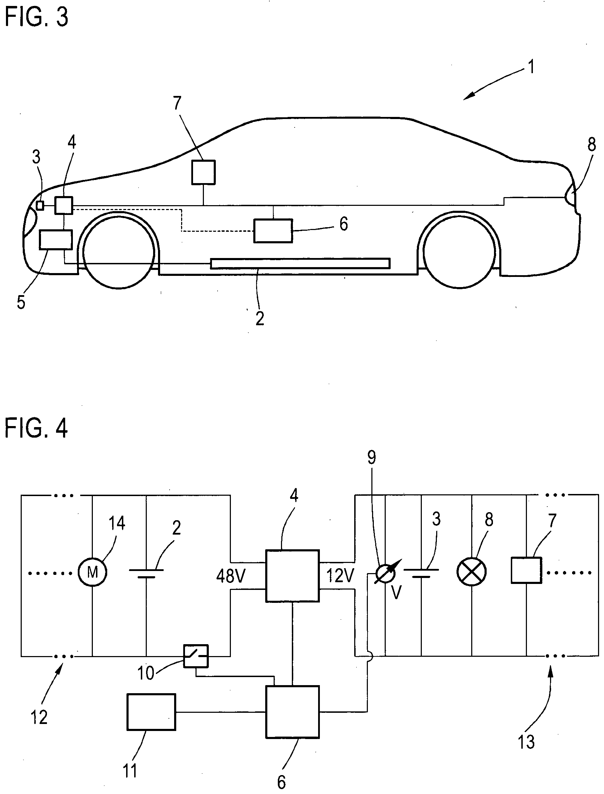

Fig. 3 zeigt ein erfindungsgemäßes Kraftfahrzeug 1. Das Kraftfahrzeug 1 umfasst eine Höherspannungsbatterie 2 und eine Niederspannungsbatterie 3. Die Höherspannungsbatterie 2 liefert hier eine Spannung von 48 V, die Niederspannungsbatterie 3 eine Spannung von 12 V. Das Kraftfahrzeug 1 weist damit zwei Bordnetze, ein mit 48 V betriebenes Netz und ein mit 12 V betriebenes Netz auf. Die beiden Bordnetze sind über den DC/DC-Konverter 4 verbunden.

Das Fahrzeug 1 weist einen Hybridmotor 5 auf. Dieser besteht aus einem Verbrennungsmotor sowie zwei Elektromotoren/Generatoren und einem Planetengetriebe, das diese drei Bestandteile verbindet. Hybridmotoren sind im Stand der Technik bekannt, daher soll hier nicht detailliert auf die Funktion des Hybridmotors 5 eingegangen werden. Wesentlich ist, dass zum Starten des Verbrennungsmotors beim Hybridmotor 5 zumindest einer der Elektromotoren mit Strom der Höherspannungsbatterie 2 betrieben wird. Als Anlasser dient hier also ein Elektromotor, der aus einer Höherspannungsbatterie 2 versorgt wird. Damit erfolgt beim Starten des Verbrennungsmotors kein Test der Niederspannungsbatterie 3. Die Niederspannungsbatterie 3 versorgt im Kraftfahrzeug 1 beispielsweise die Scheinwerfer 8 sowie verschiedene Niederspannungssysteme 7 im Innenraum des Kraftfahrzeugs und eine Steuereinrichtung 6. Die Steuereinrichtung 6 kann den DC/DC-Konverter ansteuern. Im normalen Fahrzeugbetrieb kann daher beispielsweise abhängig vom Ladezustand der Niederspannungsbatterie 3 ein stärkeres Laden der Niederspannungsbatterie oder überhaupt kein Laden der Niederspannungsbatterie allein durch Variation der Sollwerte des DC/DC-Konverters 4 durch die Steuereinrichtung 6 erreicht werden.

Durch ein kurzzeitiges Trennen des DC/DC-Konverters 4 von einem der Bordnetze, ein anschließendes Anpassen des Sollwerts der Regelung des DC/DC-Konverters 4 durch die Steuereinrichtung 6 und ein anschließendes Verbinden des DC/DC-Konverters mit den Bordnetzen für einen kurzen Zeitraum, während die Niederspannungsbatterie 3 abfallende Spannungen gemessen wird, kann die Niederspannungsbatterie getestet werden.

Fig. 4 zeigt eine schematische Darstellung der beiden Bordnetze des in Fig. 3 gezeigten Kraftfahrzeugs. Das links vom DC/DC-Konverter 4 gezeigte Höherspannungsbordnetz umfasst eine Höherspannungsbatterie 2 sowie zumindest einen Elektromotor 14. Es ist möglich, dass der Elektromotor 14 auch als Generator betreibbar ist. Im Bereich 12 ist angedeutet, dass im Höherspannungsnetz weitere Komponenten vorhanden sein können. Eine Polarität des Höherspannungsnetzes ist fest mit dem DC/DC-Konverter 4 verbunden, die andere Polarität ist über einen Schalter 10 an den DC/DC-Konverter 4 gekoppelt. Bei Öffnen des Schalters 10 durch die Steuereinrichtung 6 ist kein Stromfluss vom Niederspannungsnetz in das Höherspannungsnetz oder umgekehrt über längere Zeiträume möglich.

Das rechts gezeigte Niederspannungsnetz umfasst die Niederspannungsbatterie 3, die Scheinwerfer 8, mehrere Niederspannungsverbraucher 7 im Fahrzeuginnenraum sowie weitere Komponenten 13. Die an der Niederspannungsbatterie 3 abfallende Spannung wird mit dem Spannungsmessgerät 9 gemessen. Das Spannungsmessgerät 9 ist durch die Steuereinrichtung 6 auslesbar. Die Steuereinrichtung 6 kann zudem einen Sollwert für den DC/DC-Konverter 4 vorgeben. Zudem kann die Steuereinrichtung über eine Anzeigeeinrichtung 11, die sich im Sichtbereich des Fahrers befindet, ein Signal an den Fahrer des Kraftfahrzeugs ausgeben. Zur Durchführung des Verfahrens zum Testen der Niederspannungsbatterie wird durch die Steuereinrichtung 6 zunächst der Schalter 10 geöffnet, um einen Stromtransport durch den DC/DC-Konverter 4 zu verhindern. Anschließend wird durch die Steuereinrichtung 6 der Sollwert des DC/DC-Konverters 4 angepasst. Da im Testverfahren der DC/DC-Konverter nur für ein sehr kurzes Zeitintervall betrieben wird, kann beispielsweise die maximal mögliche Ausgangsspannung ausgegeben werden. Nun schließt die Steuereinrichtung 6 den Schalter 10. Damit fließen große Ströme aus der Niederspannungsbatterie 3 durch den DC/DC-Konverter 4 und laden die Höherspannungsbatterie 2. Nach einem kurzen Warteintervall wird durch die Steuereinrichtung 6 der Wert der Spannungsmesseinrichtung 9 ausgelesen. Anschließend wird der Schalter 10 wieder geöffnet. Ist der gelesene Spannungswert der Spannungsmesseinrichtung 9 größer als ein vorgegebener Spannungswert, ist das Verfahren abgeschlossen. Falls der Wert jedoch kleiner ist, wird durch die Steuereinrichtung 6 die Anzeigeeinrichtung 11 dermaßen angesteuert, dass eine Warnung an einen Fahrer ausgegeben wird.

## Patentansprüche

1. Verfahren zum Testen eines ersten Energiespeichers in einem Kraftfahrzeug, umfassend einen ersten Energiespeicher zum Betrieb mehrerer Fahrzeugsysteme und einen zweiten Energiespeicher, der zumindest die zum Starten des Kraftfahrzeugs benötigte elektrische Energie zur Verfügung stellt, sowie eine Steuereinrichtung, umfassend die Schritte:
- Verbinden (S2) des ersten Energiespeichers mit einem Verbraucher mit niedrigerer Impedanz als die minimale Gesamtimpedanz einer Parallelschaltung einer festgelegten Auswahl der Fahrzeugsysteme, für ein festgelegtes Zeitintervalls (S3) durch die Steuereinrichtung, wobei der Verbraucher ein bidirektionaler DC/DC Wandler des Kraftfahrzeugs ist,
- Messen (S4) einer am ersten Energiespeicher abfallenden Spannung durch die Spannungsmesseinrichtung wenigstens einmal innerhalb des Zeitintervalls,
- Ausgabe (S7) eines Signals durch die Steuereinrichtung, falls die Spannung einen vorgegebenen Grenzwert unterschreitet (S6).

2. Verfahren nach Anspruch 1,
**dadurch gekennzeichnet,**
**dass** der erste Energiespeicher ein Niederspannungsenergiespeicher und der zweite Energiespeicher ein Höherspannungsenergiespeicher ist.

3. Verfahren nach Anspruch 1 oder 2,
**dadurch gekennzeichnet,**
**dass** die Schritte vor Fahrtbeginn, insbesondere beim Einschalten der Zündung des Kraftfahrzeugs, beim öffnen einer Fahrzeugtür und/oder bei Erkennung eines zum Fahrzeug gehörenden Funkschlüssels in einer vorgegebenen Maximalentfernung durch eine Detektionseinrichtung, und/oder in regelmäßigen Abständen, insbesondere bei Betrieb des Kraftfahrzeugs oder bei stillgelegtem Kraftfahrzeug durchgeführt werden.

4. Verfahren nach einem der vorangehenden Ansprüche,
**dadurch gekennzeichnet,**
**dass** im Schritt des Verbindens des ersten Energiespeichers mit dem Verbraucher zunächst eine Referenzspannung oder ein Referenzstroms des DC/DC Konverters angepasst und der DC/DC Konverter anschließend für die Länge des Zeitintervalls mit der angepassten Referenzspannung bzw. dem angepassten Referenzstrom betrieben wird.

5. Verfahren nach einem der vorangehenden Ansprüche,
**dadurch gekennzeichnet,**
**dass** der im Zeitintervall vom Verbraucher abgegebene Strom zum Laden des zweiten Energiespeichers genutzt wird oder der Verbraucher ein Motor, ein Startgenerator oder eine Heizeinrichtung ist.

6. Verfahren nach einem der vorangehenden Ansprüche,
**dadurch gekennzeichnet,**
**dass** das Zeitintervall zwischen 2 ms und 60 s, insbesondere zwischen 200 ms und 40 s, speziell zwischen 1 s und 30 s liegt.

7. Verfahren nach einem der vorangehenden Ansprüche,
**dadurch gekennzeichnet,**
**dass** die Impedanz des Verbrauchers so gewählt wird, dass der im Zeitintervall abgegebene Strom bei einem funktionsfähigen ersten Energiespeicher, bei dem kein Signal ausgegeben wird, einen Maximalstrom-stärke von wenigstens 40 A, vorzugsweise wenigstens 200 A, im Speziellen wenigstens 300 A erreicht.

8. Verfahren nach einem der vorangehenden Ansprüche,
**dadurch gekennzeichnet,**
**dass** bei Gabe eines Signals durch die Steuereinrichtung ein Warnsignal durch eine Hinweiseinrichtung des Kraftfahrzeugs, insbesondere als akustische, optische oder haptische Benachrichtigung an einen Fahrer ausgegeben wird.

9. Verfahren nach einem der vorangehenden Ansprüche,
**dadurch gekennzeichnet,**
**dass** bei Gabe eines Signals durch die Steuereinrichtung das Kraftfahrzeug stillgelegt wird, wobei dies insbesondere bei Stillstand des Kraftfahrzeugs erfolgt.

10. Verfahren nach einem der vorangehenden Ansprüche,
**dadurch gekennzeichnet,**
**dass** bei Gabe eines Signals durch die Steuereinrichtung die Nutzung mindestens eines Fahrzeugsystems, insbesondere eines Kommunikations-, Unterhaltungs-, Fahrassistenz-, Sensor-, Heiz- oder Klimatisierungssystems und/oder Navigationssystems, unterbunden wird.

11. Verfahren nach einem der vorangehenden Ansprüche,
**dadurch gekennzeichnet,**
**dass** bei Gabe eines Signals durch die Steuereinrichtung der erste Energiespeicher vom Bordnetz des Kraftfahrzeugs getrennt wird.

12. Verfahren nach einem der vorangehenden Ansprüche,
**dadurch gekennzeichnet,**
**dass** nach Gabe eines Signals durch die Steuereinrichtung ein Wechsel in einen Betriebsmodus des Kraftfahrzeugs mit rein elektrischem Fahrbetrieb unterbunden wird und/oder ein solcher Betriebsmodus verlassen wird.

13. Kraftfahrzeug umfassend einen ersten Energiespeicher (3) zum Betrieb mehrerer Fahrzeugsysteme (7, 8) und einen zweiten Energiespeicher (2), der zumindest die zum Starten des Kraftfahrzeugs benötigte elektrische Energie zur Verfügung stellt, eine Spannungsmesseinrichtung (9) sowie mindestens eine Steuereinrichtung (6),
**dadurch gekennzeichnet,**
**dass** das Kraftfahrzeug (1) zur Durchführung eines Verfahrens nach einem der vorangehenden Ansprüche ausgebildet ist.

14. Kraftfahrzeug nach Anspruch 13,
**dadurch gekennzeichnet,**
**dass** die Steuereinrichtung (6) zur Bestimmung einer Untergrenze der an dem ersten Energiespeicher (3) abfallenden Spannung, zum Auslesen der durch die Spannungsmesseinrichtung (9) gemessenen Spannung und zur Gabe eines Signals, wenn die eine gemessenes Spannung niedriger als die Untergrenze ist, ausgebildet ist.

15. Kraftfahrzeug nach Anspruch 14,
**dadurch gekennzeichnet,**
**dass** die oder eine weitere Steuereinrichtung (6) zur Verbindung des ersten Energiespeichers (3) mit einem Verbraucher (4) niedrigerer Impedanz als die minimale Gesamtimpedanz einer Parallelschaltung einer festgelegten Auswahl der Fahrzeugsysteme (7, 8) und zur Auswertung des Signals ausgebildet ist.

16. Kraftfahrzeug nach Anspruch 15,
**dadurch gekennzeichnet,**
**dass** der Verbraucher (4) ein DC/DC Konverter ist und die Steuereinrichtung (6), die weitere Steuereinrichtung oder eine dritte Steuereinrichtung zur Vorgabe des Sollstrom oder der Sollspannung des DC/DC Konverters (4) ausgebildet ist.

## Claims

1. Method for testing a first energy store in a motor vehicle, comprising a first energy store for operating a plurality of vehicle systems and a second energy store which provides at least the electrical energy required for starting the motor vehicle, and a control device, comprising the steps of:
- connecting, by means of the control device, the first energy store to a load having an impedance that is lower than the minimum total impedance of a parallel circuit of a specified selection of the vehicle systems, (S2) for a fixed time interval (S3), wherein the load is a bidirectional DC/DC converter of the motor vehicle,
- measuring a voltage drop across the first energy store with the voltage measuring device at least once within the time interval, (S4)
- outputting a signal by means of the control device (S7) when the voltage drops below a predetermined limit value (S6).

2. Method according to claim 1,
**characterized in that**
the first energy store is a low-voltage energy store and the second energy store is a higher voltage energy store.

3. Method according to claim 1 or 2,
**characterized in that**
the steps are performed before the motor vehicle is being driven, in particular when turning on the ignition of the motor vehicle, when opening a vehicle door and/or when detecting with a detection device a wireless key belonging to the vehicle at a predetermined maximum distance, and/or at regular intervals, in particular during operation of the motor vehicle or when the motor vehicle is shut down.

4. Method according to any of the preceding claims,
**characterized in that**
in the step of connecting the first energy store to the load, a reference voltage or a reference current of the DC/DC converter is first adjusted, whereafter the DC/DC converter is operated for the duration of the time interval with the adjusted reference voltage or the adjusted reference current.

5. Method according to any of the preceding claims,
**characterized in that**
the current output by the load during the time interval is used for charging the second energy store, or the load is a motor, a starter motor or a heating device.

6. Method according to any of the preceding claims,
**characterized in that**
the time interval is between 2 ms and 60 s, in particular between 200 ms and 40 s, especially between 1 s and 30 s.

7. Method according to any of the preceding claims,
**characterized in that**
the impedance of the load is selected such that the current supplied during the time interval at a first energy store that is operative, during which no signal is outputted, has a maximum current intensity of at least 40 A, preferably at least 200 A, in particular at least 300 A.

8. Method according to any of the preceding claims,
**characterized in that**
when the control device outputs a signal, a warning signal, in particular an acoustic, optical or haptic signal, is outputted to a driver by a notification device of the motor vehicle.

9. Method according to any of the preceding claims,
**characterized in that**
when the control device outputs a signal, the motor vehicle is shut down, in particular when the motor vehicle is at a standstill.

10. Method according to any of the preceding claims,
**characterized in that**
when the control device outputs a signal, use of at least one vehicle system, in particular of a communication system, an entertainment system, a driver assistance system, a sensor system, a heating or air conditioning system and/or a navigation system, is inhibited.

11. Method according to any of the preceding claims,
**characterized in that**
when the control device outputs a signal, the first energy store is disconnected from an onboard electrical system of the motor vehicle.

12. Method according to any of the preceding claims,
**characterized in that**
after the control device has outputted a signal, a change into an operating mode of the motor vehicle with an exclusively electrical driving operation is inhibited, and/or such an operating mode is exited.

13. Motor vehicle comprising a first energy store (3) for operating a plurality of vehicle systems (7, 8) and a second energy store (2), which provides at least the electrical energy required for starting the motor vehicle, a voltage measuring device (9), and at least one control device (6),
**characterized in that**
the motor vehicle (1) is configured to perform a method according to any of the preceding claims.

14. Motor vehicle according to claim 13,
**characterized in that**
the control device (6) is configured to determine a lower limit value of the voltage drop across the first energy store (3), to read out the voltage measured by the voltage measuring device (9), and to output a signal, when the one measured voltage is lower than the lower limit value.

15. Motor vehicle according to claim 14,
**characterized in that**
the or an additional control device (6) is configured to connect the first energy store (3) to a load (4) having an impedance that is lower than the minimum total impedance of a parallel circuit of a specified selection of the vehicle systems (7, 8), and to evaluate the signal.

16. Motor vehicle according to claim 15,
**characterized in that**
the load (4) is a DC/DC converter, and the control device (6), the further control device or a third control device is configured to define the target current or the target voltage of the DC/DC converter (4).

## Revendications

1. Procédé pour le test d'un premier accumulateur d'énergie dans un véhicule automobile comprenant un premier accumulateur d'énergie pour le fonctionnement de plusieurs systèmes de véhicule et un deuxième accumulateur d'énergie, qui fournit au moins l'énergie électrique nécessaire au démarrage du véhicule automobile, ainsi qu'un dispositif de commande, ledit procédé comprenant les étapes consistant à :
- relier le premier accumulateur d'énergie à un consommateur présentant une impédance inférieure à l'impédance totale minimale d'un montage parallèle d'une sélection fixée des systèmes de véhicule (S2) pour un intervalle de temps fixé (S3) au moyen du dispositif de commande, le consommateur étant un convertisseur CC/CC bidirectionnel du véhicule automobile,
- mesurer une tension chutant au niveau du premier accumulateur d'énergie au moyen du dispositif de mesure de tension au moins une fois pendant l'intervalle de temps (S4),
- délivrer en sortie un signal au moyen du dispositif de commande (S7) si la tension devient inférieure à une valeur limite spécifiée (S6).

2. Procédé selon la revendication 1,
**caractérisé en ce**
**que** le premier accumulateur d'énergie est un accumulateur d'énergie à basse tension et le deuxième accumulateur d'énergie est un accumulateur d'énergie à haute tension.

3. Procédé selon la revendication 1 ou 2,
**caractérisé en ce**
**que** les étapes sont mises en oeuvre avant le début du trajet, en particulier lors de la mise sous tension de l'allumage du véhicule automobile, lors de l'ouverture d'une portière de véhicule et/ou lors de la détection, par un dispositif de détection, d'une clé radio appartenant au véhicule à une distance maximale spécifiée et/ou à des intervalles réguliers, en particulier lors du fonctionnement du véhicule automobile ou lorsque le véhicule automobile est arrêté.

4. Procédé selon l'une quelconque des revendications précédentes,
**caractérisé en ce**
**que**, à l'étape consistant à relier le premier accumulateur d'énergie au consommateur, on adapte d'abord une tension de référence ou un courant de référence du convertisseur CC/CC et on fait fonctionner ensuite le convertisseur CC/CC pendant tout l'intervalle de temps avec la tension de référence adaptée ou avec le courant de référence adapté.

5. Procédé selon l'une quelconque des revendications précédentes,
**caractérisé en ce**
**que** le courant fourni par le consommateur pendant l'intervalle de temps est utilisé pour charger le deuxième accumulateur d'énergie ou le consommateur est un moteur, un générateur de démarrage ou un dispositif de chauffage.

6. Procédé selon l'une quelconque des revendications précédentes,
**caractérisé en ce**
**que** l'intervalle de temps est compris entre 2 ms et 60 s, en particulier entre 200 ms et 40 s, de manière spécifique entre 1 s et 30 s.

7. Procédé selon l'une quelconque des revendications précédentes,
**caractérisé en ce**
**que** l'impédance du consommateur est choisie de telle sorte que le courant fourni pendant l'intervalle de temps, lorsque le premier accumulateur d'énergie est capable de fonctionner et qu'aucun signal n'est délivré en sortie, atteint une intensité de courant maximale d'au moins 40 A, de préférence d'au moins 200 A, de manière spécifique d'au moins 300 A.

8. Procédé selon l'une quelconque des revendications précédentes,
**caractérisé en ce**
**que**, lors de la délivrance d'un signal par le dispositif de commande, un signal d'avertissement est délivré à un conducteur au moyen d'un dispositif d'information du véhicule automobile, en particulier sous la forme d'une notification acoustique, optique ou haptique.

9. Procédé selon l'une quelconque des revendications précédentes,
**caractérisé en ce**
**que**, lors de la délivrance d'un signal par le dispositif de commande, le véhicule automobile est arrêté, ceci s'effectuant en particulier lors de l'immobilisation du véhicule automobile.

10. Procédé selon l'une quelconque des revendications précédentes,
**caractérisé en ce**
**que**, lors de la délivrance d'un signal par le dispositif de commande, l'utilisation au moins d'un système de véhicule, en particulier d'un système de communication, de divertissement, d'assistance à la conduite, de capteurs, de chauffage ou de climatisation et/ou d'un système de navigation est empêchée.

11. Procédé selon l'une quelconque des revendications précédentes,
**caractérisé en ce**
**que**, lors de la délivrance d'un signal par le dispositif de commande, le premier accumulateur d'énergie est coupé du réseau de bord du véhicule automobile.

12. Procédé selon l'une quelconque des revendications précédentes,
**caractérisé en ce**
**que**, après la délivrance d'un signal par le dispositif de commande, un passage dans un mode de fonctionnement du véhicule automobile avec un fonctionnement purement électrique est empêché, et/ou un mode de fonctionnement de ce type est quitté.

13. Véhicule automobile comprenant un premier accumulateur d'énergie (3) pour le fonctionnement de plusieurs systèmes de véhicule (7, 8) et un deuxième accumulateur d'énergie (2), qui fournit au moins l'énergie électrique nécessaire au démarrage du véhicule automobile, un dispositif de mesure de tension (9) ainsi qu'au moins un dispositif de commande (6),
**caractérisé en ce**
**que** le véhicule automobile (1) est réalisé pour la mise en oeuvre d'un procédé selon l'une quelconque des revendications précédentes.

14. Véhicule automobile selon la revendication 13,
**caractérisé en ce**
**que** le dispositif de commande (6) est réalisé pour déterminer une limite inférieure de la tension chutant au niveau du premier accumulateur d'énergie (3), pour lire la tension mesurée par le dispositif de mesure de tension (9) et pour délivrer un signal lorsque la tension mesurée est inférieure à la limite inférieure.

15. Véhicule automobile selon la revendication 14,
**caractérisé en ce**
**que** le dispositif de commande (6) ou un autre dispositif de commande est réalisé pour relier le premier accumulateur d'énergie (3) à un consommateur (4) présentant une impédance inférieure à l'impédance totale minimale d'un montage parallèle d'une sélection fixée des systèmes de véhicule (7, 8) et pour évaluer le signal.

16. Véhicule automobile selon la revendication 15,
**caractérisé en ce**
**que** le consommateur (4) est un convertisseur CC/CC, et le dispositif de commande (6), l'autre dispositif de commande ou un troisième dispositif de commande est réalisé pour spécifier le courant de consigne ou la tension de consigne du convertisseur CC/CC (4).
